# EUROPÄISCHE PATENTSCHRIFT

(11) **EP 3 180 627 B1**
(45) Veröffentlichungstag und Bekanntmachung des Hinweises auf die Patenterteilung: **15.05.2024**
(21) Anmeldenummer: 15756122.6
(22) Anmeldetag: 12.08.2015
(51) Int. Cl.: G01R 31/327

(54) **PRÜFSYSTEM UND VERFAHREN ZUR PRÜFUNG EINES LEISTUNGSSCHALTERS**
TEST SYSTEM AND METHOD FOR TESTING A CIRCUIT BREAKER
SYSTÈME ET PROCÉDÉ DE TEST D'UN DISJONCTEUR

(30) Priorität: 12.08.2014 AT 505612014
(43) Veröffentlichungstag der Anmeldung: 21.06.2017
(73) Patentinhaber: Omicron electronics GmbH, 6833 Klaus (AT)
(72) Erfinder: KLAPPER, Ulrich, A-6830 Rankweil (AT)
(74) Vertreter: Kraus & Lederer PartGmbB
(86) Internationale Anmeldenummer: PCT/EP2015/068531
(87) Internationale Veröffentlichungsnummer: WO 2016/023941

(56) Entgegenhaltungen:
- US-A- 5 065 101
- US-B1- 6 545 479
- "CIBANO500 3-in-1 test system for medium-and high-voltage circuit breakers", , 7. Juli 2014 (2014-07-07), Seiten 1-20, XP055217034, Gefunden im Internet: URL:https://web.archive.org/web/2014070721 5038/https://www.omicron.at/fileadmin/user _upload/pdf/literature/CIBANO-500-brochure -ENU.pdf [gefunden am 2015-09-29]

## Beschreibung

Die vorliegende Erfindung betrifft ein Prüfsystem sowie ein Verfahren zur Prüfung eines Leistungsschalters einer elektrischen Schaltanlage.

Es existieren mehrere Arten von Prüfgeräten zur Prüfung von verschiedenen Typen von Schaltern, die im Nieder-, Mittel- und Hochspannungsbereich betrieben werden. Ein Beispiel für derartige Schalter sind Leistungsschalter. Leistungsschalter, welche auch als Hochspannungsschalter oder "Circuit Breaker" bezeichnet werden, sind spezielle Schalter, welche für hohe Ströme ausgelegt sind. In energietechnischen Anlagen, wie z.B. Energieerzeugungsanlagen wie Kraftwerken oder Energieübertragungsanlagen, schalten Leistungsschalter nicht nur Betriebsströme, sondern bei Fehlern auch hohe Überlastströme oder Kurzschlussströme. Leistungsschalter können sowohl zum Einschalten dieser Ströme als auch zum Ausschalten der Ströme verwendet werden. Ein Leistungsschalter umfasst üblicherweise einen Schaltkontakt und einen Steuerantrieb, welcher den Schaltkontakt mechanisch antreibt. Der Steuerantrieb kann beispielsweise Federantriebe oder Druckluftantriebe umfassen, welche mechanische Energie speichern, die zum schnellen Schalten des Schaltkontakts verwendet wird. Die Feder- oder Druckluftantriebe können beispielsweise mit elektrischen Antrieben vorgespannt oder "aufgeladen" werden. Das Freigeben der gespeicherten mechanischen Energie zum Schalten des Schaltkontakts kann über sogenannte Auslösespulen, welche elektrisch angesteuert werden, erfolgen. In den elektrischen Anlagen gibt es üblicherweise eine Stationsbatterie, die eine Gleichspannung (DC-Spannung) zwischen 48 und 220V zur Verfügung stellt, um die Auslösespulen mit Energie zu versorgen. Zum Öffnen oder Schließen wird dann lediglich noch ein potentialfreier Relaiskontakt benötigt. Im Betrieb kommen die Kommandos zum Öffnen oder Schließen üblicherweise von Schutzrelais oder der Leittechnik.

US 6 545 479 B1 offenbart einen Leistungsschaltertester zum Testen eines Stromtransformators eines Leistungsschalters, wobei der Stromtransformator einen ersten Anschluss an einem ersten Ende des Transformators und einen zweiten Anschluss an einem zweiten Ende des Transformators aufweist. Der Leistungsschaltertester umfasst einen Testanschluss, der so konfiguriert ist, dass er mit dem ersten und dem zweiten Anschluss verbunden werden kann, und einen Teststromkreis, der mit dem Testanschluss verbunden ist und so konfiguriert ist, dass er einen Teststrom durch den Testanschluss an den ersten Anschluss liefert, um den zweiten Anschluss durch den Testanschluss zu überwachen und um ein Ausgangssignal an eine Anzeige bereitzustellen, basierend darauf, ob der Teststrom am zweiten Anschluss empfangen wird.

Es werden unter dem Begriff "Leistungsschalter" auch Lastschalter, Trenner oder Erdungstrenner verstanden.

Leistungsschalter sind zentrale Komponenten in elektrischen Schaltanlagen und müssen daher in regelmäßigen Abständen gewartet und überprüft werden, um deren einwandfreie Funktion gewährleisten zu können.

Im Normalbetrieb sind Teile der Leistungsschalter häufig mit einer Stationsbatterie der entsprechenden Schaltanlage verbunden, welche die Leistungsschalter mit der benötigten Energie versorgt und somit gewährleistet, dass die Leistungsschalter ihre vorgesehene Funktion erfüllen. Wird ein Leistungsschalter geprüft, muss der Leistungsschalter während der Prüfung zumindest kurzzeitig mit Energie versorgt werden, um einerseits eingebaute Energiespeicher, wie zum Beispiel Federn oder komprimiertes Gas, auf- oder nachzuladen und andererseits die gespeicherte Energie freizuschalten, um den Leistungsschalter effektiv zu aktivieren. Unter bestimmten Bedingungen kann - insbesondere bei Trennern - auch ohne Energiespeicher gearbeitet werden. In diesem Fall muss die Energie im Moment der Schalterbetätigung von außen zugeführt werden.

Herkömmlicherweise können dazu Prüfsysteme eingesetzt werden, welche die benötigte Versorgungsspannung aus der Netzspannung selbst erzeugen. Dies hat den Vorteil, dass die Spannung variiert werden kann und somit auch Prüfungen unterhalb und oberhalb der Nennspannung der Stationsbatterie durchgeführt werden können. Insbesondere so genannte Unterspannungsprüfungen erlauben eine gute Beurteilung, ob der Leistungsschalter auch bei schwacher Batterie noch arbeiten würde.

Eine weitere Möglichkeit besteht darin, zur Versorgung des zu prüfenden Leistungsschalters während der Prüfung direkt die Stationsbatterie zu verwenden. In diesem Fall kann das Verhalten des Leistungsschalters bei einer Unterspannung nicht geprüft werden. Es besteht aber die Möglichkeit, zwischen Stationsbatterie und Leistungsschalter einen Widerstand einzuschleifen. Damit fällt am Widerstand ein Teil der Spannung ab, und es entsteht am Leistungsschalter eine Unterspannung. Die Versorgungsspannung hängt in diesem Fall vom Stromfluss ab und kann somit stark schwanken, was die Qualität der Messung negativ beeinflussen kann.

Die vorliegende Erfindung stellt sich daher die Aufgabe, ein Prüfsystem und ein Verfahren zur Prüfung von Leistungsschaltern bereit zu stellen, womit die zuvor beschriebenen Probleme vermieden werden können.

Erfindungsgemäß wird diese Aufgabe durch ein Prüfsystem zur Prüfung eines Leistungsschalters einer elektrischen Schaltanlage nach Anspruch 1 sowie ein Prüfverfahren nach Anspruch 10 gelöst.

Die abhängigen Ansprüche definieren weitere Ausführungsformen der vorliegenden Erfindung.

Es wird ein Prüfsystem für einen Leistungsschalter einer elektrischen Schaltanlage bereitgestellt, das ein Prüfgerät umfasst, wobei die Energie zur Betätigung des Leistungsschalters von einer Stationsbatterie der elektrischen Schaltanlage, welche vorzugsweise im Normalbetrieb des Leistungsschalters als dessen Spannungsversorgung dient, entnommen und mittels eines Spannungsreglers des Prüfgeräts stabilisiert wird. Im Rahmen der vorliegenden Erfindung werden unter dem Begriff "Leistungsschalter" auch Lastschalter, Trenner oder Erdungstrenner verstanden.

Der Vorteil dieser Anordnung besteht darin, dass es somit zur Prüfung des Leistungsschalters nicht notwendig ist, eine separate Spannungsquelle für die Erzeugung der Prüf- bzw. Versorgungsspannung für den Leistungsschalter vorzusehen, da die bereits am Ort des Leistungsschalters existierende Stationsbatterie als Spannungsquelle genutzt werden kann. Mögliche Spannungsschwankungen der Stationsbatterie können mit Hilfe des Spannungsreglers des Prüfgeräts ausgeregelt werden, so dass am Ausgang des Prüfgeräts eine vom Laststrom möglichst unabhängige und konstant gehaltene Versorgungsspannung für den Lastschalter bereitgestellt wird. Alternativ kann, was zwar nicht Teil der Erfindung, aber nützlich zu deren Verständnis ist, anstelle der Stationsbatterie der elektrischen Schaltanlage auch eine andere Spannungsquelle verwendet werden, welche ohnehin am Ort der Prüfung des Leistungsschalters vorhanden ist.

Darüber hinaus kann das Prüfgerät Schaltmittel, beispielsweise in Form eines Auslösekontakts, umfassen, welche eine Auslösespule des Leistungsschalters selektiv mit der Versorgungsspannung ansteuern, wenn er geschlossen wird.

Trotz Anschluss an die Stationsbatterie zur Versorgung der Auslösespule(n) des Leistungsschalters kann das Prüfgerät einen herkömmlichen Netzanschluss umfassen, mit dem beispielsweise die Kontrolllogik oder die Messelektronik versorgt wird. Wahlweise kann aber auch die Verbindung zur Stationsbatterie die einzige Versorgung des Prüfgeräts sein.

Während der Prüfung des Leistungsschalters empfängt vorzugsweise eine Messeinheit des Prüfgeräts Messsignale von dem Leistungsschalter und wertet sie aus, um somit das Auslöseverhalten des Leistungsschalters bzw. dessen Reaktion auf die angelegte Versorgungsspannung bewerten zu können.

Der zu prüfende Leistungsschalter kann Schaltmittel, beispielsweise in Form eines Hauptkontakts, umfassen, welche mit der Auslösespule verbunden sind. Wird die Auslösespule wie oben beschrieben mit der Versorgungsspannung angesteuert, können diese Schaltmittel in Abhängigkeit von der Größe der Versorgungsspannung ausgelöst werden.

Die von der Stationsbatterie bereitgestellte Eingangsspannung kann eine Nennspannung aufweisen, die nicht variabel ist und einen konstanten Wert aufweist. In manchen Ausführungsformen der vorliegenden Erfindung kann es daher wünschenswert sein, den Wert der Eingangsspannung zu verändern, um verschiedene Prüfszenarien mit unterschiedlichen Auslösespannungen auf den Leistungsschalter anzuwenden. Dazu können vorteilhaft verschiedene Ausführungsformen von Spannungsreglern verwendet werden.

In einem Ausführungsbeispiel kann die Spannungsregelung mit Hilfe eines linearen Spannungsreglers erzielt werden. Diese Ausführungsform ist auf Fälle anwendbar, bei denen die Versorgungsspannung kleiner als die Eingangsspannung ist. Der Vorteil dieser Anordnung besteht darin, dass Unterspannungen und das zugehörige Verhalten des Leistungsschalters geprüft werden können.

In einem weiteren bevorzugten Ausführungsbeispiel kann ein geschalteter Spannungsregler verwendet werden, wobei mit Hilfe geeigneter Leistungselektronik eine kleinere Versorgungsspannung erzeugt werden kann und gleichzeitig die Verlustleistung minimiert wird. Dadurch kann der Eingangsstrom in Abhängigkeit von der Spannungsdifferenz zwischen der Eingangsspannung und der Versorgungsspannung auch kleiner sein als der Strom, mit dem das Prüfgerät den Leistungsschalter ansteuert.

Darüber hinaus kann der Spannungsregler auch ein Tiefsetzsteller sein. Der Ausgangsstrom des Tiefsetzstellers ist höher als dessen mittlerer Eingangsstrom und die Ausgangsspannung kleiner als die Eingangsspannung. Daraus ergibt sich bei Verwendung eines Tiefsetzstellers in dem Prüfgerät, dass diese Ausführungsform auf Fälle anwendbar ist, bei denen die Versorgungsspannung des Prüfgeräts kleiner oder gleich der Eingangsspannung ist.

In einem weiteren Ausführungsbeispiel kann der Spannungsregler auch ein Hochsetzsteller sein. In diesem Fall ist die Ausgangsspannung des Hochsetzstellers größer als die Eingangsspannung. Bei Einsatz eines Hochsetzstellers wird die Versorgungsspannung des Prüfgeräts somit größer oder gleich der von der Stationsbatterie bereitgestellten Eingangsspannung sein. Ein Vorteil der Verwendung eines Hochsetzstellers besteht somit darin, auch Spannungen, die höher sind als die Spannung der externen Spannungsquelle bzw. der Stationsbatterie, an dem Leistungsschalter testen zu können.

Darüber hinaus kann auch eine Kombination aus Hoch- und Tiefsetzsteller gewählt werden, um den Spannungsregler zu realisieren. Der Vorteil dieser Anordnung besteht darin, dass der Spannungsbereich des Ausgangs des Prüfgeräts dann frei wählbar ist und sowohl Unterspannungs- als auch Überspannungsprüfungen durchgeführt werden können. Insbesondere sogenannte Unterspannungsprüfungen ermöglichen eine effiziente Beurteilung, ob der Leistungsschalter auch bei schwacher Batterie korrekt funktioniert.

Bei allen vorgeschlagenen Ausführungsformen des Spannungsreglers kann bei der Erzeugung der Prüfspannung, d.h. der Versorgungsspannung für den jeweiligen Leistungsschalter, diese von dem Spannungsregler vorteilhaft stabilisiert werden, um Schwankungen in der von der Stationsbatterie gelieferten Eingangsspannung auszugleichen und zu kompensieren. Dadurch kann eine Prüfung des Leistungsschalters mit einer hohen Güte und Genauigkeit realisiert werden.

Es wird außerdem ein Prüfgerät zur Prüfung eines Leistungsschalters einer elektrischen Schaltanlage bereitgestellt, welches ausgestaltet ist, um aus einer Spannung einer Stationsbatterie der elektrischen Schaltanlage eine Versorgungsspannung für die Prüfung des Leistungsschalters zu erzeugen, wobei das Prüfgerät einen Spannungsregler zum Stabilisieren der Versorgungsspannung umfasst. Das Prüfgerät kann vorzugsweise wie zuvor beschrieben ausgestaltet sein.

Weiterhin angegeben wird ein Verfahren zur Durchführung einer Prüfung eines Leistungsschalters einer elektrischen Schaltanlage, wobei ein Prüfgerät mit einer Stationsbatterie der elektrischen Schaltanlage gekoppelt wird, um eine Eingangsspannung von der Stationsbatterie an das Prüfgerät anzulegen. Das Prüfgerät wird mit dem zu prüfenden Leistungsschalter gekoppelt und die Versorgungsspannung für den Leistungsschalter zur Prüfung des Leistungsschalters aus der Spannung der Stationsbatterie erzeugt, wobei die Versorgungsspannung mit Hilfe eines Spannungsreglers des Prüfgeräts stabilisiert wird. Das Verhalten des Leistungsschalters bei angelegter Versorgungsspannung wird mit Hilfe einer Messeinheit des Prüfgeräts erfasst und analysiert.

Im Folgenden werden erfindungsgemäße Ausführungsformen im Detail unter Bezugnahme auf die Zeichnung beschrieben.
Fig. 1 zeigt ein Prüfsystem gemäß einer Ausführungsform der vorliegenden Erfindung.
Fig. 2 zeigt eine Darstellung eines Verfahrens zur Prüfung eines Leistungsschalters mit dem vorgeschlagenen Prüfsystem.

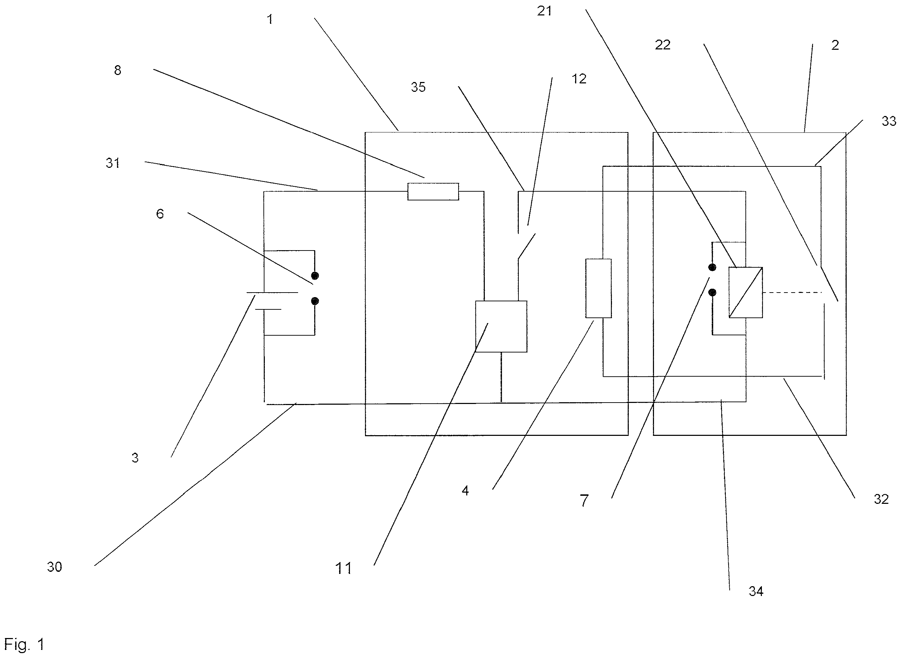

Fig. 1 zeigt ein Prüfsystem, welches ein Prüfgerät 1 zum Prüfen eines Leistungsschalters 2 umfasst. Der Leistungsschalter 2 ist Bestandteil einer elektrischen Schaltanlage, welche auch eine Stationsbatterie 3 umfasst, die im Normalbetrieb den Leistungsschalter 2 mit einer Betriebsspannung versorgt. Das Prüfgerät 1 kann zum Zweck der Prüfung des Leistungsschalters 2 temporär in der Schaltanlage aufgestellt sein.

Die Stationsbatterie stellt in der Regel eine Gleichspannung zur Verfügung, die in manchen Ausführungsbeispielen im Bereich von 48V bis 220V liegen kann. In Fig. 1 ist diese Spannung als Eingangsspannung 6 gekennzeichnet.

Um den Leistungsschalter 2 zu prüfen, wird das Prüfgerät 1 zwischen die Stationsbatterie 3 und den Leistungsschalter 2 geschaltet. Dabei wird das Prüfgerät 1 über Verbindungen 30 und 31 derart an die Stationsbatterie 3 angeschlossen, dass das Prüfgerät 1 mit der Eingangsspannung 6 versorgt wird. Das Prüfgerät 1 umfasst bei der dargestellten Ausführungsform unter anderem einen Spannungsregler 11, einen Schalter in Form eines Auslösekontakts 12 und eine Messeinheit 4. Außerdem kann das Prüfgerät in einem Ausführungsbeispiel einen variablen und/oder einschleifbaren Widerstand 8 zur entsprechenden Anpassung der Eingangsspannung des Prüfgeräts 1 umfassen. Die Eingangsspannung 6 liegt an dem Spannungsregler 11 an, wobei zwischen der Stationsbatterie 3 und dem Spannungsregler 11 der Widerstand 8 eingeschleift werden kann. Der Spannungsregler 11 ist über Verbindungen 34 und 35 mit dem Leistungsschalter 2 verbunden. Die Verbindung 35 umfasst dabei einen Schalter in Form eines Auslösekontakts 12, mit dem der Stromkreis, der durch die Verbindungen 34 und 35 definiert ist, wahlweise geöffnet oder geschlossen werden kann. Eine Messeinheit 4 des Prüfgeräts 1 ist über Verbindungen 32 und 33 mit dem Leistungsschalter 2 gekoppelt.

Aus der von der Stationsbatterie 3 bereitgestellten Eingangsspannung 6 wird von dem Prüfgerät 1 eine Versorgungsspannung 7 zum Prüfen des Leistungsschalters 2 erzeugt. Der Spannungsregler 11 ist vorteilhafterweise derart ausgelegt, dass er die Versorgungsspannung 7 für den Leistungsschalter 2 stabilisiert und mögliche Schwankungen, die in der von der Stationsbatterie 3 bereitgestellten Spannung 6 auftreten können, ausgleicht oder auch gezielt verkleinert oder vergrößert. Der Spannungsregler 11 kann dabei in verschiedenen Ausführungsformen realisiert sein.

Beispielsweise kann der Spannungsregler 11 ein linearer Spannungsregler sein. Dieser ist dadurch gekennzeichnet, dass er nur solche Versorgungsspannungen 7 bereitstellt, die kleiner als die Eingangsspannung 6 sind. Dabei ist der Strom, der durch die Eingangsspannung 6 der Stationsbatterie 3 erzeugt wird, größer oder gleich dem Strom, mit dem das Prüfgerät 1 den Leistungsschalter 2 ansteuert. Die Differenzspannung zwischen der Eingangsspannung 6 und der Versorgungsspannung 7 multipliziert mit dem Strom wird in dem Prüfgerät 1 in Wärme umgesetzt.

In einem weiteren Ausführungsbeispiel kann der Spannungsregler 11 ein geschalteter Spannungsregler sein, der mit einer geeigneten Leistungselektronik ausgestattet ist. In diesem Fall wird ebenfalls eine Versorgungsspannung 7 bereitgestellt, welche kleiner als die Eingangsspannung 6 ist, wobei aber die Verlustleistung klein gehalten werden kann. Außerdem kann je nach Spannungsdifferenz zwischen Eingangsspannung 6 und Versorgungsspannung 7 der Strom, der durch die Eingangsspannung 6 der Stationsbatterie 3 erzeugt wird, kleiner sein als der Strom, mit dem das Prüfgerät 1 den Leistungsschalter 2 ansteuert.

Darüber hinaus kann der Spannungsregler 11 auch ein Tiefsetzsteller sein. Die Versorgungsspannung 7 ist in diesem Fall kleiner oder gleich der Eingangsspannung 6. In einem weiteren möglichen Ausführungsbeispiel kann der Spannungsregler 11 ein Hochsetzsteller sein. In diesem Fall ist die Versorgungsspannung 7 größer oder gleich der Eingangsspannung 6. Es ist auch möglich, für den Spannungsregler 11 eine Kombination aus Hoch- und Tiefsetzsteller zu wählen, wobei die Versorgungsspannung 7 dann frei wählbar ist.

Durch eine geeignete Wahl des Typs des Spannungsreglers 11 kann somit das Prüfsystem an die jeweils vorhandenen Prüfbedingungen angepasst werden, wobei insbesondere die Größe der Versorgungsspannung 7 entsprechend variabel gewählt werden kann.

Der in Fig. 1 gezeigte Auslösekontakt 12 dient dazu, den Stromkreis, der durch die Verbindungen 34 und 35 definiert ist, wahlweise zu öffnen oder zu schließen und die Versorgungsspannung 6, die von dem Spannungsregler 11 zur Verfügung gestellt wird, über die Verbindungen 34 und 35 an eine Auslösespule 21 des zu prüfenden Leistungsschalters 2 anzulegen. Wird der Auslösekontakt 12 geschlossen, liegt an der Auslösespule 21 die Versorgungsspannung 7 an, mit der die Auslösespule 21 betätigt werden kann. Je nach Höhe der an die Spule 21 angelegten Spannung 7 öffnet oder schließt die Auslösespule 21 einen Hauptkontakt 22 des Leistungsschalters 2 schnell, weniger schnell oder gar nicht.

Die Messeinheit 4 des Prüfgeräts 1 empfängt Messsignale des Leistungsschalters 2, anhand derer die Messeinheit 4 automatisch eine Bewertung des Auslöseverhaltens des Leistungsschalters 2 bzw. dessen Hauptkontakts 22 vornehmen kann.

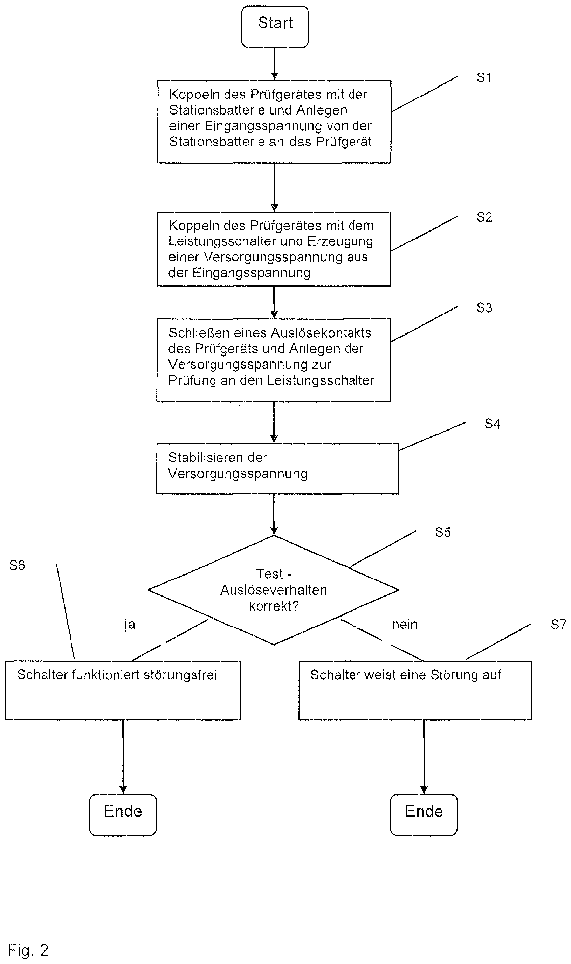

Fig. 2 zeigt eine Darstellung zur Erläuterung eines Verfahrens zur Prüfung eines Leistungsschalters. Dabei wird in einem ersten Schritt S1 das Prüfgerät mit der Stationsbatterie der elektrischen Schaltanlage gekoppelt, um somit eine Spannung der Stationsbatterie als eine Eingangsspannung an das Prüfgerät anzulegen.

In einem nächsten Schritt S2 wird das Prüfgerät mit dem zu prüfenden Leistungsschalter gekoppelt, wobei das Prüfgerät aus der Spannung der Stationsbatterie eine Versorgungsspannung zur Prüfung des Leistungsschalters erzeugt.

In einem weiteren Schritt S3 wird der Auslösekontakt des Prüfgeräts geschlossen und somit die Versorgungsspannung an den zu prüfenden Leistungsschalter angelegt. Während der Prüfung des Auslöseverhaltens des Leistungsschalters wird in einem Schritt S4 die Versorgungsspannung mit dem Spannungsregler des Prüfgeräts stabilisiert, so dass dem Leistungsschalter eine konstante Prüfspannung ohne Schwankungen zugeführt werden kann.

In Abhängigkeit von dem jeweils gewählten Wert der Versorgungsspannung wird der zu prüfende Leistungsschalter schnell, weniger schnell oder nicht auslösen. In einer vorteilhaften Ausführungsform kann die Auswahl der Versorgungsspannung so gestaltet sein, dass sie unterhalb eines bestimmten Schwellenwerts liegt. In diesem Fall wird der Leistungsschalter bei einer fehlerfreien Funktion nicht auslösen. In einer weiteren Ausführungsform kann die Versorgungsspannung so gewählt werden, dass sie über dem bestimmten Schwellenwert liegt, so dass der Leistungsschalter bei einer fehlerfreien Funktion auslöst. In einem Schritt S5 wird demzufolge von der Messeinheit des Prüfgeräts geprüft, ob der Leistungsschalter entsprechend der jeweils gewählten Versorgungsspannung ein korrektes Auslöseverhalten aufweist.

Ist das Auslöseverhalten korrekt, wird in einem Schritt S6 festgestellt, dass der Leistungsschalter fehlerfrei auslöst. Falls das Auslöseverhalten nicht korrekt ist, wird hingegen in einem Schritt S7 festgestellt, dass der Leistungsschalter eine Störung aufweist.

## Patentansprüche

1. Prüfsystem zur Prüfung eines Leistungsschalters einer elektrischen Schaltanlage, umfassend:
- eine Stationsbatterie (3) der elektrischen Schaltanlage, welche vorgesehen und ausgestaltet ist, den Leistungsschalter (2) im Normalbetrieb mit einer Gleichspannung zwischen 48V und 220V als Betriebsspannung (6) zum Schalten eines Schaltkontakts des Leistungsschalters (2) zu versorgen, und
- ein Prüfgerät (1), welches zum Prüfen des Leistungsschalters (2) mit der Stationsbatterie (3) und dem Leistungsschalter (2) derart koppelbar ist und ausgestaltet ist, dass das Prüfgerät (1) mit der Betriebsspannung (6) der Stationsbatterie (3) versorgt wird und zum Prüfen des Leistungsschalters (2) eine Versorgungsspannung (7) für den Leistungsschalter (2) aus der Betriebsspannung (6) der Stationsbatterie (3) erzeugt, wobei das Prüfgerät (1) einen Spannungsregler (11) umfasst, der ausgestaltet ist, die Versorgungsspannung (7) des Leistungsschalters (2) zu stabilisieren, und wobei das Prüfgerät (1) eine Messeinheit (4) zum Analysieren eines Auslöseverhaltens des Leistungsschalters (2) bei angelegter Versorgungsspannung (7) umfasst.

2. Prüfsystem nach Anspruch 1, **dadurch gekennzeichnet, dass** das Prüfgerät (1) Schaltmittel (12) umfasst, die ausgestaltet sind, die Versorgungsspannung (7) selektiv an eine Auslösespule (21) des Leistungsschalters (2) anzulegen.

3. Prüfsystem nach einem der Ansprüche 1-2, **dadurch gekennzeichnet, dass** das Prüfgerät (1) eine Messeinheit (4) umfasst, die ausgestaltet ist, Messsignale von dem Leistungsschalter (2) zu empfangen und auszuwerten.

4. Prüfsystem nach Anspruch 1, **dadurch gekennzeichnet, dass** der Leistungsschalter (2) Schaltmittel (22) und eine Auslösespule (21) umfasst, wobei das Prüfgerät (1) dazu ausgestaltet ist, die Versorgungsspannung (7) für den Leistungsschalter (2) an die Auslösespule (21) des Leistungsschalters (2) anzulegen und die Schaltmittel (22) des Leistungsschalters (2) durch die Auslösespule (21) aktivierbar sind.

5. Prüfsystem nach einem der Ansprüche 1-4, **dadurch gekennzeichnet, dass** der Spannungsregler (11) ein linearer Spannungsregler ist.

6. Prüfsystem nach einem der Ansprüche 1 -4, **dadurch gekennzeichnet, dass** der Spannungsregler (11) ein geschalteter Spannungsregler ist.

7. Prüfsystem nach einem der Ansprüche 1-4, **dadurch gekennzeichnet, dass** der Spannungsregler (11) ein Tiefsetzsteller ist.

8. Prüfsystem nach einem der Ansprüche 1-4. **dadurch gekennzeichnet, dass** der Spannungsregler (11) ein Hochsetzsteller ist.

9. Prüfsystem nach einem der Ansprüche 1-4, **dadurch gekennzeichnet, dass** der Spannungsregler (11) ein kombinierter Tiefsetzsteller und Hochsetzsteller ist.

10. Verfahren zur Prüfung eines Leistungsschalters einer elektrischen Schaltanlage, mit folgenden Schritten:
- Koppeln eines Prüfgerätes (1) mit einer Stationsbatterie (3) der elektrischen Schaltanlage, welche vorgesehen und ausgestaltet ist, den Leistungsschalter (2) im Normalbetrieb mit einer Gleichspannung zwischen 48V und 220V als Betriebsspannung (6) zum Schalten eines Schaltkontakts des Leistungsschalters (2) zu versorgen, und Anlegen der Betriebsspannung (6) von der Stationsbatterie (3) an das Prüfgerät (1),
- Koppeln des Prüfgerätes (1) mit dem Leistungsschalter (2) und Erzeugen einer Versorgungsspannung (7) für den Leistungsschalter (2) aus der Betriebsspannung (6) der Stationsbatterie (3) zum Prüfen des Leistungsschalters (2),
- Stabilisieren der Versorgungsspannung (7) mit Hilfe eines Spannungsreglers (1) des Prüfgeräts (1), und
- Analysieren eines Auslöseverhaltens des Leistungsschalters (2) bei angelegter Versorgungsspannung (7) mit einer Messeinheit (4) des Prüfgeräts (1).

11. Verfahren nach Anspruch 10, **dadurch gekennzeichnet, dass** zur Prüfung des Leistungsschalters (2) ein Prüfsystem nach einem der Ansprüche 1-9 verwendet wird.

## Claims

1. A test system for testing a circuit breaker of an electrical switchgear assembly, comprising:
- a sub-station battery (3) of the electrical switchgear assembly, which is provided and configured to supply the circuit breaker (2) in normal operation with a DC voltage between 48V and 220V as operating voltage (6) for switching a switching contact of the circuit breaker (2), and
- a testing device (1) which, for testing the circuit breaker (2), can be coupled to the sub-station battery (3) and the circuit breaker (2) and is configured such that the testing device (1) is supplied with the operating voltage (6) of the sub-station battery (3) and, for testing the circuit breaker (2), generates a supply voltage (7) for the circuit breaker (2) from the operating voltage (6) of the sub-station battery (3), wherein the test device (1) comprises a voltage regulator (11) which is configured to stabilize the supply voltage (7) of the circuit breaker (2), and wherein the test device (1) comprises a measuring unit (4) for analyzing a trip behavior of the circuit breaker (2) when the supply voltage (7) is applied.

2. The test system according to claim 1, **characterized in that** the test device (1) comprises switching means (12) which are configured to selectively apply the supply voltage (7) to a trip coil (21) of the circuit breaker (2).

3. The test system according to any one of claims 1-2, **characterized in that** the test device (1) comprises a measuring unit (4) which is configured to receive and evaluate measurement signals from the circuit breaker (2).

4. The test system according to claim 1, **characterized in that** the circuit breaker (2) comprises switching means (22) and a trip coil (21), wherein the test device (1) is configured to apply the supply voltage (7) for the circuit breaker (2) to the trip coil (21) of the circuit breaker (2) and the switching means (22) of the circuit breaker (2) can be activated by the trip coil (21).

5. The test system according to any one of claims 1-4, **characterized in that** the voltage regulator (11) is a linear voltage regulator.

6. The test system according to one of claims 1 -4, **characterized in that** the voltage regulator (11) is a switched voltage regulator.

7. The test system according to one of claims 1-4, **characterized in that** the voltage regulator (11) is a step-down converter.

8. The test system according to one of claims 1-4, **characterized in that** the voltage regulator (11) is a step-up converter.

9. The test system according to one of claims 1-4, **characterized in that** the voltage regulator (11) is a combined step-down converter and step-up converter.

10. A method for testing a circuit breaker of an electrical switchgear assembly, comprising the following steps:
- coupling a test device (1) to a sub-station battery (3) of the electrical switchgear assembly, which is provided and configured to supply the circuit-breaker (2) in normal operation with a DC voltage between 48 V and 220 V as operating voltage (6) for switching a switching contact of the circuit-breaker (2), and applying the operating voltage (6) from the sub-station battery (3) to the test device (1),
- coupling the test device (1) to the circuit-breaker (2) and generating a supply voltage (7) for the circuit-breaker (2) from the operating voltage (6) of the sub-station battery (3) for testing the circuit-breaker (2),
- stabilizing the supply voltage (7) by means of a voltage regulator (1) of the test device (1), and
- analyzing a trip behavior of the circuit breaker (2) with a measuring unit (4) of the test device (1) when the supply voltage (7) is applied.

11. The method according to claim 10, **characterized in that** a test system according to any one of claims 1-9 is used for testing the circuit breaker (2).

## Revendications

1. Système de test permettant de tester un disjoncteur d'une installation de distribution électrique, comprenant :
- une batterie de station (3) de l'installation de distribution électrique, laquelle batterie de station est prévue et configurée pour alimenter le disjoncteur (2), lors du fonctionnement normal, avec une tension continue comprise entre 48 V et 220 V comme tension de fonctionnement (6) pour la commutation d'un contact de commutation du disjoncteur (2), et
- un appareil de test (1) qui, pour tester le disjoncteur (2), peut être couplé à la batterie de station (3) et au disjoncteur (2) et est configuré de telle sorte que l'appareil de test (1) est alimenté avec la tension de fonctionnement (6) de la batterie de station (3) et, pour tester le disjoncteur (2), génère une tension d'alimentation (7) pour le disjoncteur (2) à partir de la tension de fonctionnement (6) de la batterie de station (3), dans lequel l'appareil de test (1) comprend un régulateur de tension (11) qui est configuré pour stabiliser la tension d'alimentation (7) du disjoncteur (2), et dans lequel l'appareil de test (1) comprend une unité de mesure (4) permettant d'analyser un comportement de déclenchement du disjoncteur (2) lorsque la tension d'alimentation (7) est appliquée.

2. Système de test selon la revendication 1, **caractérisé en ce que** l'appareil de test (1) comprend un moyen de commutation (12) qui est configuré pour appliquer sélectivement la tension d'alimentation (7) à une bobine de déclenchement (21) du disjoncteur (2).

3. Système de test selon l'une des revendications 1 à 2, **caractérisé en ce que** l'appareil de test (1) comprend une unité de mesure (4) qui est configurée pour recevoir et évaluer des signaux de mesure en provenance du disjoncteur (2).

4. Système de test selon la revendication 1, **caractérisé en ce que** le disjoncteur (2) comprend un moyen de commutation (22) et une bobine de déclenchement (21), dans lequel l'appareil de test (1) est configuré pour appliquer la tension d'alimentation (7) pour le disjoncteur (2) à la bobine de déclenchement (21) du disjoncteur (2) et le moyen de commutation (22) du disjoncteur (2) peut être activé par la bobine de déclenchement (21).

5. Système de test selon l'une des revendications 1 à 4, **caractérisé en ce que** le régulateur de tension (11) est un régulateur de tension linéaire.

6. Système de test selon l'une des revendications 1 à 4, **caractérisé en ce que** le régulateur de tension (11) est un régulateur de tension à découpage.

7. Système de test selon l'une des revendications 1 à 4, **caractérisé en ce que** le régulateur de tension (11) est un convertisseur abaisseur.

8. Système de test selon l'une des revendications 1 à 4, **caractérisé en ce que** le régulateur de tension (11) est un convertisseur élévateur.

9. Système de test selon l'une des revendications 1 à 4, **caractérisé en ce que** le régulateur de tension (11) est un convertisseur abaisseur et un convertisseur élévateur combinés.

10. Procédé permettant de tester un disjoncteur d'une installation de distribution électrique, comportant les étapes suivantes :
- couplage d'un appareil de test (1) à une batterie de station (3) de l'installation de distribution électrique, laquelle batterie de station est prévue et configurée pour alimenter le disjoncteur (2), lors du fonctionnement normal, avec une tension continue comprise entre 48 V et 220 V comme tension de fonctionnement (6) pour la commutation d'un contact de commutation du disjoncteur (2), et application de la tension de fonctionnement (6) de la batterie de station (3) à l'appareil de test (1),
- couplage de l'appareil de test (1) au disjoncteur (2) et génération d'une tension d'alimentation (7) pour le disjoncteur (2) à partir de la tension de fonctionnement (6) de la batterie de station (3) pour tester le disjoncteur (2),
- stabilisation de la tension d'alimentation (7) à l'aide d'un régulateur de tension (1) de l'appareil de test (1), et
- analyse d'un comportement de déclenchement du disjoncteur (2) au moyen d'une unité de mesure (4) de l'appareil de test (1) lorsque la tension d'alimentation (7) est appliquée.

11. Procédé selon la revendication 10, **caractérisé en ce que,** pour tester le disjoncteur (2), un système de test selon l'une des revendications 1 à 9 est utilisé.
